# EUROPEAN PATENT APPLICATION

(11) **EP 4 206 823 A1**
(43) Date of publication of application: **05.07.2023**
(21) Application number: 21218401.4
(22) Date of filing: 30.12.2021
(51) Int. Cl.: G03F 7/20, G03F 1/62

(54) **METHOD OF PATTERNING A TARGET LAYER, APPARATUS FOR PATTERNING A TARGET LAYER**

(71) Applicant: ASML Netherlands B.V., 5500 AH Veldhoven (NL)
(72) Inventor: PARAYIL VENUGOPALAN, Syam, 5500 AH Veldhoven (NL); FARAZ, Tahsin, 5500 AH Veldhoven (NL)
(74) Representative: ASML Netherlands B.V.

(57) **Abstract**

Methods and apparatus are disclosed for patterning a target layer by selectively removing material. In one arrangement, the target layer is irradiated with a patterned beam. The patterned beam generates a plasma in a plasma pattern that locally interacts with the target layer to define where material is to be removed from the target layer. A bias voltage is applied to the substrate during the irradiation to control a distribution of energies of ions of the plasma impinging on the target layer.

## Description

### FIELD

The present disclosure relates to methods and apparatus for patterning a target layer by selectively removing material from the target layer. The methods and apparatus are particularly applicable to patterning two-dimensional materials, for example for manufacturing FET devices.

### BACKGROUND

As semiconductor manufacturing processes continue to advance, the dimensions of circuit elements have continually been reduced while the amount of functional elements, such as transistors, per device has been steadily increasing, following a trend commonly referred to as 'Moore's law'. To keep up with Moore's law the semiconductor industry is seeking technologies that enable creation of increasingly smaller features.

For some types of electronic device, scaling down of the device features can cause performance challenges, such as the short-channel effect that occurs in MOSFETs when the channel length becomes comparable to the depletion layer widths of the source and drain junctions. These challenges can sometimes be addressed using two-dimensional materials, which are atomically thin and can have relatively low dielectric constants.

Various deposition technologies exist for fabricating two-dimensional materials. Such deposition technologies include chemical vapor deposition (CVD), mechanical cleaving (exfoliation), molecular beam epitaxy (MBE), atomic layer deposition (ALD), liquid-phase exfoliation, and others. A challenge with many of these deposition technologies has been the high temperatures that are required for the processes to work efficiently (with high speed and quality). High temperatures can degrade or damage previously deposited layers and/or restrict the range of previously deposited layers that can be used. The previously deposited layers must be formed so that they can withstand the high temperatures to an acceptable degree, for example by having melting points above the temperatures reached during the deposition process.

In approaches based on exfoliation, the two-dimensional material can be grown offline without restrictions on temperature, but it is difficult to perform the exfoliation and transfer process with high throughput and low defectivity.

Patterning two-dimensional materials presents further challenges due to their fragile nature. Two-dimensional materials can be damaged or delaminated very easily. Two-dimensional materials can be damaged, for example, by traditional patterning processes such as resist coating, lithography, etch and resist stripping. Typical photoresists for DUV and EUV lithography may also be incompatible with two-dimensional materials, for example by being hydrophilic while the two-dimensional materials are hydrophobic. Even where great care is taken during processing, this physical incompatibility will result in unwanted sticking of resist residues on structures and a reduction in a quality of contact between the structures and other layers.

Laser etching has been proposed for patterning two-dimensional materials. Laser etching uses a laser to locally heat the surface to gradually melt material and remove the material by evaporation. Laser processing techniques rely on scanning from point to point, which lowers yield relative to some alternative approaches.

### SUMMARY

It is an object of the invention to provide alternative or improved methods of patterning target layers.

According to an aspect, there is provided a method of patterning a target layer on a substrate by selectively removing material from the target layer, wherein the method comprises: irradiating the target layer with a patterned beam of electromagnetic radiation, the patterned beam generating a plasma in a plasma pattern that locally interacts with the target layer to define where material is to be removed from the target layer; and applying a bias voltage to the substrate during the irradiation to control a distribution of energies of ions of the plasma impinging on the target layer.

Thus, a patterned beam of radiation is used to locally generate a plasma that defines where material is to be removed by interacting with the target layer. By simultaneously controlling a distribution of energies of ions in the plasma during the interaction it is possible to control the interaction with a high level of precision. This allows the target layer to be patterned with high precision and control.

In an embodiment, the radiation has a wavelength below 100nm. This allows the plasma to be generated efficiently and promotes high spatial resolution.

In an embodiment, the material is removed from the target layer by the plasma during the irradiation. Thus, the interaction between the plasma and the target layer directly removes material from the target layer.

In an embodiment, the material is removed from the target layer in a separate step after the irradiation. Thus, the interaction between the plasma and the target layer locally modifies the target layer. A subsequent processing step can then remove portions of the target layer with high precision based on whether the modification is present or not.

In an embodiment, the distribution of energies of ions is controlled such that removal of material from the target layer is performed selectively with respect to material in a layer adjacent to the target layer and having a different composition to the target layer. Thus, the control provided by the bias voltage allows etching to be performed more precisely, with minimal or no risk to damage of adjacent layers of material.

In an embodiment, the bias voltage waveform has a frequency of less than 1 MHz. Using such lower frequency waveforms reduces or avoids electron heating mechanisms that would inhibit control of ion energy independently of ion flux.

In an embodiment, the bias voltage waveform is non-sinusoidal. Providing a non-sinusoidal bias voltage makes it possible to reduce variations in the electric field within a sheath volume directly adjacent to the target layer, thereby reducing a range of energies of ions impinging on the target layer 22. Reducing the range of energies of ions means that are greater proportion of the ions can be made to contribute to providing the desired interaction with the target layer 22, thereby improving throughput, whilst also reducing the risk of damage to adjacent layers from undesirably energetic ions.

In an embodiment, each period of the bias voltage waveform comprises: a negative bias portion during which positive ions of the plasma are attracted towards the target layer; and a positive bias portion during which electrons of the plasma are attracted towards the target layer. In such an arrangement, the voltage of the bias voltage waveform may furthermore be arranged to vary during at least a majority of the negative bias portion in such a manner as to at least partially compensate for charging of the target layer and/or substrate caused by impingement of the ions during the negative bias portion. Compensating for the charging of the target layer in this manner contributes to reducing the range of energies of ions impinging on the target layer by reducing variations in the electric field within the shield volume.

In an embodiment, the variation of the voltage of the bias voltage waveform during the negative bias portion is substantially linear during at least a majority of the negative bias portion. This approach has been found to provide a good balance of ease of implementation and efficient compensation for charging of the target layer and reduction of variations in the electric field in the sheath volume.

In an embodiment, the variation of the voltage of the bias voltage waveform during the negative bias portion is such as to maintain a substantially time invariant electric field within a sheath volume directly adjacent to the target layer during the negative bias portion. Maintaining a substantially time invariant electric field within the sheath volume promotes a high level of control of energies of ions impinging on the target layer, thereby promoting high throughput and selectivity.

According to an aspect, there is provided an apparatus for patterning a target layer on a substrate, comprising: a substrate table configured to support a substrate having a target layer; a projection system configured to irradiate the target layer by projecting a patterned beam of electromagnetic radiation onto the target layer; a container arrangement configured to contain the target layer in a controlled gaseous environment during the irradiation of the target layer by the patterned beam, the controlled gaseous environment being such that the patterned beam generates a plasma in a plasma pattern to define where material is to be removed from the target layer; and a plasma-controlling bias voltage unit configured to apply a bias voltage to the substrate during the irradiation to control a distribution of energies of ions of the plasma impinging on the target layer.

### BRIEF DESCRIPTION OF THE DRAWINGS

Embodiments of the invention will now be described, by way of example only, with reference to the accompanying schematic drawings, in which:
Figure 1 depicts a first example of a lithographic system comprising a lithographic apparatus and a radiation source;
Figure 2 depicts a second example of a lithographic system comprising a lithographic apparatus and a radiation source;
Figure 3 schematically depicts irradiation of a target layer by a patterned beam in a controlled gaseous environment held within a container arrangement having a transparent pellicle;
Figure 4 depicts graphs to illustrate different etching regimes; the upper graph shows a variation of etching rate (ER) as a function of ion energy (IE); the lower graph shows the ion energy distribution function (IEDF) for two different bias voltage waveforms;
Figure 5 schematically depicts variation of voltage at the target layer against time in a transient phase shortly after an initial turning on of a bias voltage;
Figure 6 schematically depicts variation of voltage at the target layer against time in a steady state;
Figure 7 is a graph showing three example sinusoidal bias voltage waveforms having different amplitudes;
Figure 8 is a graph showing distributions of ion energies corresponding to the bias voltage waveforms shown in Figure 7;
Figure 9 depicts an example non-sinusoidal bias voltage waveform;
Figure 10 is a graph showing three example non-sinusoidal bias voltage waveforms having different amplitudes;
Figure 11 is a graph showing distributions of ion energies corresponding to the bias voltage waveforms shown in Figure 10;
Figure 12 schematically depicts irradiation of a target layer by a patterned beam to produce modified regions in a pattern corresponding to the pattern of the patterned beam; and
Figure 13 depicts the result of selectively removing the modified regions produced in Figure 12 to apply a pattern to the target layer.

### DETAILED DESCRIPTION

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus which uses extreme ultraviolet (EUV) radiation, having a wavelength of less than 100nm, optionally in the range of 5-100 nm, optionally within a range of 4 nm to 20 nm, for example 6.7 nm or 13.5 nm, may be used to form smaller features on a substrate than a lithographic apparatus which uses, for example, radiation with a wavelength of 193 nm.

In the present document, the terms "radiation" and "beam" are used to encompass all types of electromagnetic radiation unless stated otherwise, including ultraviolet radiation (e.g. with a wavelength of 365, 248, 193, 157 or 126 nm) and EUV (extreme ultra-violet radiation, e.g. having a wavelength in the range of about 5-100 nm), as well as electron beam radiation.

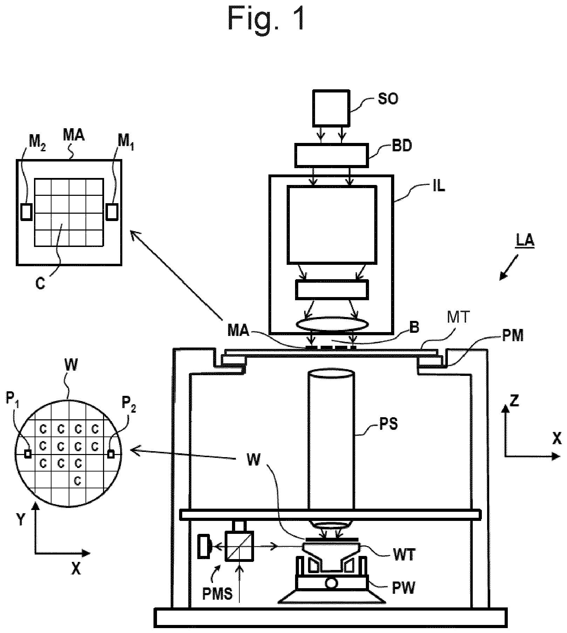

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

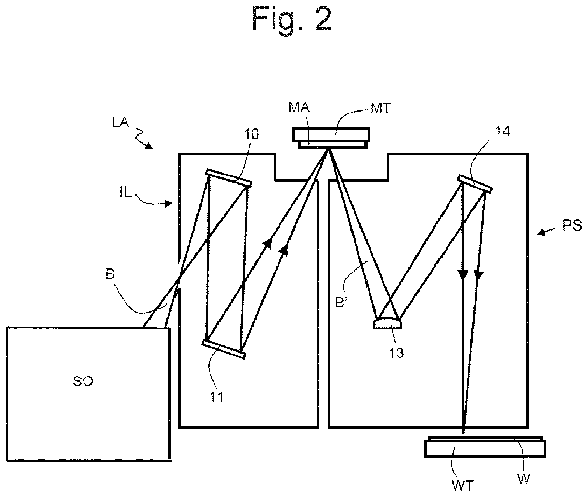

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As mentioned in the introductory part of the description, although there is interest in using two-dimensional materials in semiconductor manufacturing processes, there are challenges in achieving sufficiently high crystalline quality and/or throughput and/or low defectivity. Deposition processes such as CVD and ALD require high temperatures, which can damage underlying layers. For example, typical CVD processes for producing high quality monolayers of two-dimensional crystals can require temperatures higher than 800°C, whereas temperatures above 500°C are typically incompatible with back end of the line CMOS technology. The thermal budget for Si FinFets (fin field-effect transistors), for example, is less than 1050°C for front end of the line (FEOL) and less than 400°C for back end of the line (BEOL). For 2D-FETs (field-effect transistors based on two-dimensional materials) this budget is much lower (typically 450-500°C for both FEOL and BEOL). Exfoliation-based processes avoid these thermal constraints because the deposition of the two-dimensional material can be performed at a separate location, but the transfer process is complex and it is difficult to avoid high defectivity. Traditional patterning processes such as resist coating, lithography, etch and resist stripping are also problematic because they can damage two-dimensional materials. Moreover, conventional lithography techniques represent a challenge for patterning 2D material layers. Due to the nature of these materials, the resulting structures are contaminated and/or damaged with rough edges after a lithography (DUV, EUV, EBL) followed by (dry-, wet-) etch step. Contacts to other layers e.g. source and drain electrodes are not optimal, resulting in a ~ 3.5 times larger Schottky barrier compared to where clean and sharp interfaces are provided.

An alternative approach using EUV-induced deposition can form patterns of two-dimensional material directly, without any resist processing. Examples of such deposition are described in WO2019166318, WO2020207759 and in EP patent application 20160615.9, all hereby incorporated in their entirety by reference. It can be difficult, however, with EUV-induced deposition to achieve sufficiently high growth rates of two-dimensional material. The EUV dose (the amount of energy deposited per unit area by the EUV radiation) is constrained in practice to be below a predetermined EUV dose limit to avoid damage to the surface being irradiated and/or underlying layers. A typical EUV dose limit may be 100 mJ/cm² for example.

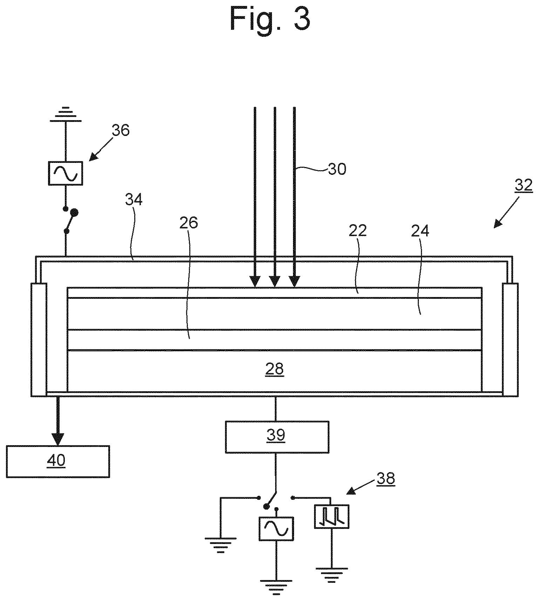

Referring to Figure 3, embodiments of the present disclosure provide methods and apparatus for patterning a target layer 22. The patterning involves irradiating the target layer 22 with a patterned beam 30 of electromagnetic radiation. The irradiation may be performed using any of the arrangements discussed above with reference to Figures 1 and 2. An apparatus for performing the methods may therefore comprise a projection system PS such as that described above with reference to Figures 1 and 2 configured to irradiate the target layer 22 by projecting the patterned beam onto the target layer 22.

The target layer 22 is provided on a substrate 24. The substrate 24 may comprise a silicon wafer, for example, and/or one or more pre-existing layers on the wafer (e.g., between the target layer 22 to be patterned and the silicon of the wafer). The pre-existing layer, or each of the pre-existing layers, may be continuous or patterned. A layer directly adjacent and in contact with the target layer 22 may be referred to as a support layer. The support layer may comprise a material on which it is desired to form a two-dimensional material as a step in a manufacturing process (e.g., of an electronic device such as a 2D-FET). The support layer may comprise one or more of the following: Al₂O₃; SiO₂; HfO₂; Sn; SnO₂; In₂O₃; Indium Tin Oxide (ITO). The support layer may particularly preferably comprise one or more of Sn; SnO₂; In₂O₃; ITO.

The target layer 22 is patterned by selectively removing material from the target layer 22 using the irradiation. The selective removal is selective in the sense that a portion of the target layer 22 is removed and another portion of the target layer 22 is left behind. A pattern is thereby formed in the target layer 22. The selective removal of material from the target layer 22 may comprise removing all of the thickness of the target layer 22 in selected portions of the target layer 22 or removing only a portion of the thickness of the target layer 22 in selected portions of the target layer 22.

The patterned beam 30 generates a plasma in a plasma pattern. The pattern of the plasma pattern corresponds to, for example is the same as, the pattern of the patterned beam. The plasma pattern locally interacts with the target layer 22 to define where material is to be removed from the target layer 22. In some embodiments, the method comprises applying a bias voltage to the substrate during the irradiation to control a distribution of energies of ions of the plasma impinging on the target layer 22. The distribution of energies of ions may be controlled such that removal of material from the target layer 22 is performed selectively with respect to material in a layer adjacent to the target layer 22 (e.g. a support layer) that has a different composition to the target layer 22. The removal may thus be selective with respect to a layer underneath the target layer 22 as well as with respect to which portions of the target layer 22 are removed to pattern the target layer 22. Further details about the control of the distribution of energies of ions are given later.

In some embodiments, the target layer 22 comprises, consists essentially of, or consists of, a two-dimensional material. A two-dimensional material is a material that shows significant anisotropy of properties in lateral directions within a plane of the material compared to the direction perpendicular to the plane of the material. A class of two-dimensional materials are sometimes referred to as singlelayer materials, or monolayers, and may comprise crystalline materials consisting of a single layer of atoms or a small number of single layers of atoms on top of each other. In some embodiments, the two-dimensional material comprises, consists essentially of, or consists of, one or more of the following: one or more 2D allotropes such as graphene and antimonene; one or more inorganic compounds such as MXenes, hexagonal boron nitride (hBN), and a transition metal dichalcogenide (TMD) (a semiconductor of the type MX₂, which may be atomically thin, with the letter M referring to a transition metal atom (e.g. Mo or W) and the letter X referring to a chalcogen atom (e.g. S, Se, or Te)), for example WS₂, MoS₂, WSe₂, MoSe₂, etc. The two-dimensional material may comprise a layer of M atoms sandwiched between two layers of X atoms. The two-dimensional material may comprise any semiconductor two-dimensional material suitable for use as a transistor channel. As mentioned above, the two-dimensional material may compromise a 2D allotrope e.g. graphene or antimonene, or an inorganic compound. The two-dimensional material may comprise a monolayer (or multiple monolayers if the deposition process is repeated).

The target layer 22 may be provided as a spatially uniform layer prior to the irradiation by the patterned beam, e.g., a layer having a spatially constant composition and/or thickness within the plane of the layer. The target layer 22 may be provided by uniformly coating the substrate 24. The target layer 22 may be provided using any of various known deposition processes. The deposition process may comprise for example one or more of the following independently or in combination: atomic layer deposition; chemical vapor deposition; plasma-enhanced chemical vapor deposition; epitaxy; sputtering; and electron beam-induced deposition. The patterning of the target layer 22 may constitute a step in a method of forming at least one layer of a device to be manufactured, such as a semiconductor device. The two-dimensional material may, for example, form a channel of an FET or a metal cap or diffusion barrier in an interconnect.

In an embodiment, the irradiation is performed with radiation that comprises, consists essentially of, or consists of radiation having a wavelength less than 100nm (which may also be referred to as EUV radiation). The use of EUV radiation facilitates effective generation of a plasma, as well as providing high spatial resolution. In some other embodiments, the irradiation is performed with radiation comprising, consisting essentially of, or consisting of, higher wavelength radiation. The higher wavelength radiation may be in the range of 100nm to 400nm (including DUV radiation).

In some embodiments, as exemplified in Figure 3, the substrate 24 on which the target layer 22 is provided is held in a controlled gaseous environment during the irradiation by the patterned beam 30. The controlled gaseous environment is contained by a container arrangement 32. The container arrangement 32 may comprise a pellicle 34 (e.g., a thin membrane) that is substantially transparent to the patterned beam 30 while still acting to limit or prevent movement of particles through the pellicle 34. The pellicle 34 may for example seal the container arrangement 32 and be substantially transparent to EUV radiation. The patterned radiation beam passes through the pellicle 34 onto the target layer 22 during the irradiation. The container arrangement 32 should typically be capable of maintaining the controlled gaseous environment at a pressure substantially below atmospheric pressure. The container arrangement 32 may be configured to provide conditions similar to those provided in an EUV scanner vacuum environment for example. It is desirable to keep pressures relatively low in the controlled gaseous environment to allow efficient interaction between ions from the plasma and the target layer during the irradiation of the target layer with the patterned beam. Higher pressures would interfere with the directionality and/or energy distribution of ions bombarding the target layer 22.

In some embodiments, a plasma-forming bias voltage is applied to the pellicle 34 during the irradiation by the patterned beam 30 to promote formation of the plasma. The plasma-forming bias voltage may be provided by a plasma-forming bias voltage unit 36. The plasma-forming bias voltage may comprise a radio frequency bias voltage, for example in the range of 1 kHz to 100 MHz. The plasma-forming bias voltage may be configured to promote formation of a plasma in a portion of the gaseous environment adjacent to the target layer 22 when that portion of the gaseous environment is irradiated by the patterned beam 30. The substrate 24 may be attached to a substrate table 28 by an electrostatic chuck 26. A plasma-controlling bias voltage unit 38 is provided for applying a bias voltage to the substrate table 28. The bias voltage may be applied via a well-tuned matching box or blocking capacitor network 39. The plasma-controlling bias voltage unit 38 may be used to apply the bias voltage to the substrate that controls the distribution of energies of ions of the plasma impinging on the target layer 22.

The gaseous environment may comprise one or more inert gases, such as He, Ne, Kr, Xe. Alternatively or additionally, the gaseous environment may comprise one or more chemically reactive gases, such as hydrogen, fluorine, chlorine, etc. The gaseous environment may contain a combination of inert and chemically reactive gases. A pump 40 may be provided to allow particles to be pumped out of the container arrangement 32 when required (e.g., to change a composition of the gaseous environment when the etching process comprises multiple stages, such as in atomic layer etching, and/or to remove etch products). Inlets (not shown), valves, gas pressure sensors etc. (not shown) may be provided to allow particles to be introduced to the container arrangement 32 to achieve a desired composition within the gaseous environment.

In one class of embodiment, the material is removed from the target layer 22 by the plasma during the irradiation by the patterned beam 30. The removal may occur by physical sputter etching (e.g., involving a plasma formed from one or more inert gases in the container arrangement 32) and/or chemical sputter etching (involving a plasma formed from one or more chemically reactive gases in the container arrangement 32) and/or a synergetic combination of physical sputtering and chemical etching known as ion-assisted etching. A localized radiation-induced plasma is created. The plasma generates energetic and directional ions. The ions drive patterned etching of the target layer 22. The ions create volatile etch products that are pumped out of the container arrangement 32 by the pump 40. The removal of material may be a continuous etch process (e.g., reactive ion etching) or a self-limited etch process (e.g., atomic layer etching).

In some embodiments, a pre-processing step is performed before the removal of material by the plasma. For example, the target layer 22 may be exposed to a reactive gas to modify the target layer 22. For example, a two-dimensional layer of MoS₂ could be exposed to chlorine to form chlorinated MoS₂. The plasma generated during the irradiation by the patterned beam 30 locally generates plasma species (e.g., Ar+ ions) that are energized by the applied bias voltage and selectively remove the modified target layer 22 (e.g., chlorinated MoS₂), thereby patterning the target layer 22.

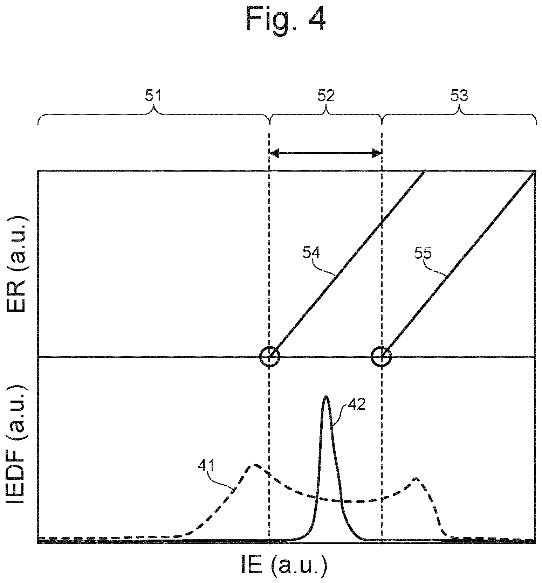

Depending on the energies of the impinging ions, there can be different etching regimes, as described below with reference to Figure 4.

Figure 4 depicts two graphs. The upper graph schematically depicts variation of etching rate (ER) as a function of ion energy (IE). The lower graph depicts an ion energy distribution function (IEDF) defining how the ion energies are distributed over the range of ion energies. The ion energy distributions depend on the bias voltage applied to the substrate 24 during the irradiation with the patterned beam 30. Two example curves are shown in Figure 4. Curve 41 represents a case where a radio frequency bias voltage is applied that has a sinusoidal waveform. Curve 42 represents a case where a radio frequency bias voltage is applied that has a tailored (non-sinusoidal) waveform (described in further detail below).

Referring to the upper graph in Figure 4, three regimes of ion energy can be identified. In regime one, indicated by ion energy range 51, ions have energies that are too low to cause significant, or any, etching of the target layer 22 (etch rate ER shown as zero). In regime two, indicated by ion energy range 52, an etching rate of the target layer 22 is non-zero and increases with increasing ion energy (curve 54). A rate of etching of material adjacent to the target layer 22 (e.g., material of a support layer underlying the target layer 22) remains low or zero in regime two. The removal of material from the target layer 22 by ions having energies in regime two is thus selective with respect to material adjacent to the target layer 22. In regime three, indicated by ion energy range 53, an etching rate of the material adjacent to the target layer 22 becomes non-zero and increases with increasing ion energy (curve 55). The boundary between regime one and regime two may be referred to as a first threshold energy defining a minimum ion energy for etching material of the target layer 22. The boundary between regime two and regime three may be referred to as a second threshold energy defining a minimum ion energy for etching material adjacent to the target layer 22 and having a different composition to the target layer 22. Ions in regime three can cause significant etching to occur in both the target layer 22 and in the underlying material.

It is desirable to operate in a process window where ions have a range of energies that are predominantly or exclusively within regime two. In some embodiments, the distribution of energies of ions comprises a maximum between the first threshold energy and the second threshold energy. In some embodiments, all local maxima in the distribution of energies of ions are between the first and second threshold energies. It is desirable for the global maximum to be between the first and second threshold energies. In some embodiments, the distribution of energies comprises a single maximum and the single maximum is between the first and second threshold energies.

In some embodiments, the bias voltage applied by the plasma-controlling bias voltage unit 38 comprises a radio frequency waveform. In some embodiments, the frequency of the bias voltage waveform is less than 1 MHz.

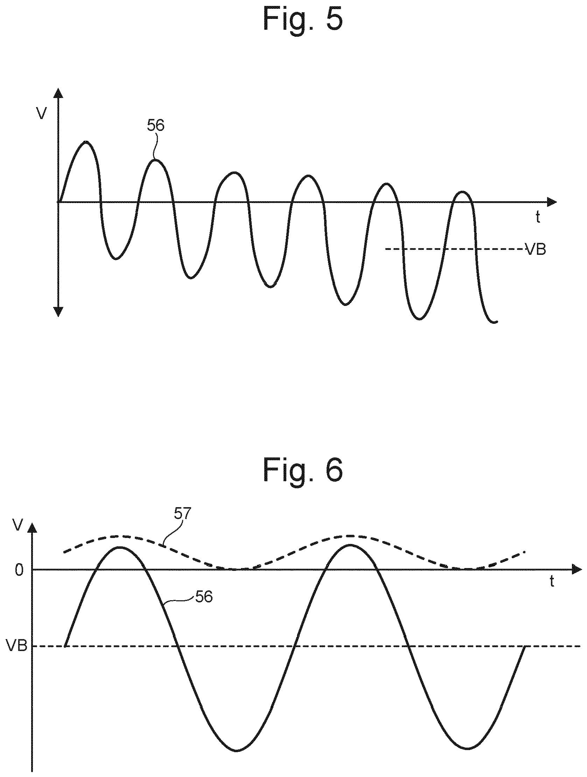

In some embodiments, the bias voltage waveform is sinusoidal. Figures 5 and 6 schematically depict example variations of voltage at the target layer 22 against time (curves 56), respectively in a transient phase (Figure 5) and in a steady state (Figure 6). As shown Figure 5, the voltage at the target layer 22 drifts during the transient phase as the target layer 22 becomes negatively charged due to the greater mobility of the relatively light negatively charged electrons in the plasma in comparison with the heavier positively charged ions. In presence of a well-tuned matching box or blocking capacitor network 39, the voltage drifts until the waveform is such that no net charging of the target layer 22 occurs when considered over a whole cycle (period) of the applied bias voltage waveform. The DC shift observed in the steady state may be referred to as a DC bias voltage.

The energies of ions impinging on the target layer 22 depend on how the electric field varies in a sheath volume adjacent to the target layer 22 during the applied bias voltage. This electric field depends on the difference in voltage between the bulk of the plasma and the voltage at the target layer 22. The voltage in the bulk of the plasma varies relatively little as a function of time in comparison to the voltage in the sheath volume nearer to the target layer 22. Curve 57 in Figure 6 depicts schematically how the voltage in the bulk of the plasma is expected to vary as a function of time. The voltage in the bulk of the plasma varies with a much smaller amplitude than the voltage at the target layer 22. When a sinusoidal bias voltage is applied, this results in the electric field varying as a function of time in a manner that leads to a relatively wide and bimodal spread in the distribution of energies of ions impinging on the target layer 22. This is exemplified by curve 41 in the lower graph of Figure 4. Having a wide distribution of ion energies can lead to undesired scenarios. In the example of curve 41 in Figure 4, it can be seen for example that relatively large proportions of the ions have energies that are in regime three (which would cause undesirable etching of material adjacent to the target layer 22) and in regime one (which do not contribute to any etching and thereby lower throughput).

Low frequency bias voltage waveforms (e.g., less than 1 MHz) lead to broader energy distributions than higher frequency bias voltage waveforms, when sinusoidal waveforms are used. However, use of higher frequency waveforms can entail electron heating mechanisms that do not allow for controlling the ion energy independently of the ion flux.

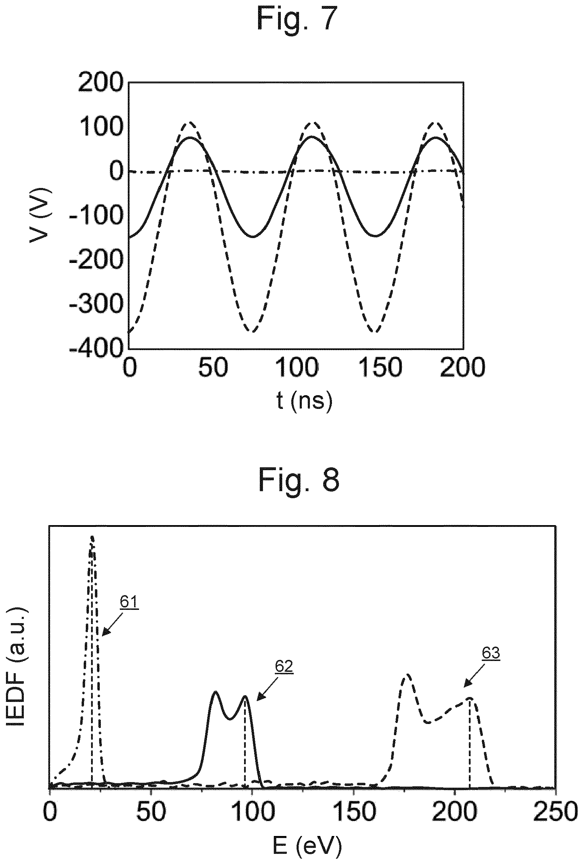

The distribution of energies of ions can be shifted along the energy axis by varying the amplitude of the bias voltage waveform. This is illustrated in Figures 7 and 8. In Figure 7, three different bias voltage waveforms are shown with three different amplitudes and the same frequency. Figure 8 shows corresponding distributions of ion energies. Curve 61 (dot-dash line) shows the distribution of energies resulting from applying the lowest amplitude bias voltage waveform in Figure 7. Curve 62 (solid line) shows the distribution of energies resulting from applying the intermediate amplitude bias voltage waveform in Figure 7. Curve 63 (broken line) shows the distribution of energies resulting from applying the highest amplitude bias voltage waveform in Figure 7. As the amplitude is increased, it is seen that the spread of energies becomes bimodal and increases in width.

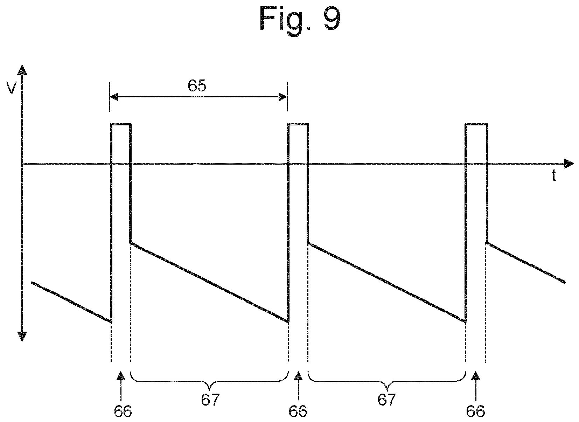

In some embodiments, a non-sinusoidal bias voltage waveform is applied. An example of such a bias voltage waveform is shown in Figure 9. Each period 65 of the bias voltage waveform comprises a positive bias portion 66 and a negative bias portion 67. A sum of the durations of the positive bias portion 66 and the negative bias portion 67 may equal the period 65 of the bias voltage waveform. The voltage applied during the negative bias portion 67 is such that positive ions of the plasma are attracted towards the target layer 22. The voltage applied during the positive bias portion 66 is such that electrons of the plasma are attracted towards the target layer 22. The low masses of the electrons means the electrons will respond very quickly to changes in the direction of the electric field and will in essence flow onto the target layer 22 only during the positive bias portion 66. By contrast, the much heavier ions will flow onto the target layer 22 not only during the negative bias portion 67 but also during at least a portion of the positive bias portion 66 due to inertial effects. In some embodiments, the duration of the positive bias portion is selected (e.g., is sufficiently short) such that ions continue to flow to the target layer due to inertial effects during all of the positive bias portion.

In some embodiments, as exemplified in Figure 9, the duration of the positive bias portion 66 is shorter than the duration of the negative bias portion 67. The positive bias portion 66 may, for example, be less than one quarter of the period 65 of the bias voltage waveform, preferably less than 1/5 of the period 65, preferably less than 1/6 of the period 65, preferably less than 1/8 of the period 65, preferably less than 1/10 of the period.

In some embodiments, the voltage of the bias voltage waveform is substantially constant during at least a majority of the positive bias portion 66.

In some embodiments, the voltage of the bias voltage waveform varies during at least a majority of the negative bias portion 67 in such a manner as to at least partially compensate for charging of the target layer 22 and/or substrate 24 caused by impingement of the ions during the negative bias portion. Charging will occur for example where the target layer 22 and/or a layer below the target layer 22 is dielectric. Arranging for the bias voltage to compensate the charging decreases variation of the electric field in the sheath volume adjacent to the target layer 22, thereby contributing to a reduced spread of energies in the distribution of energies of ions impinging on the target layer 22.

In some embodiments, as exemplified in Figure 9, the variation of the voltage of the bias voltage waveform during the negative bias portion 67 is substantially linear during at least a majority of the negative bias portion 67, (as shown in Figure 9). In some embodiments, the variation of the voltage of the bias voltage waveform during the negative bias portion 67 is such as to maintain a substantially time invariant electric field within the sheath volume directly adjacent to the target layer 22 during the negative bias portion 67.

Use of a non-sinusoidal bias voltage waveform facilities provision of a distribution of energies of ions that has a single maximum (mono-modal), as exemplified by curve 42 in Figure 4, or plural local maxima that are close together in energy. The non-sinusoidal bias voltage waveform thus facilities provision of a distribution of energies of ions that comprises a maximum between the first threshold energy (between regimes one and two mentioned above with reference to Figure 4) and the second threshold energy (between regimes two and three mentioned above with reference to Figure 4), and/or no local maximum below the first threshold energy or above the second threshold energy.

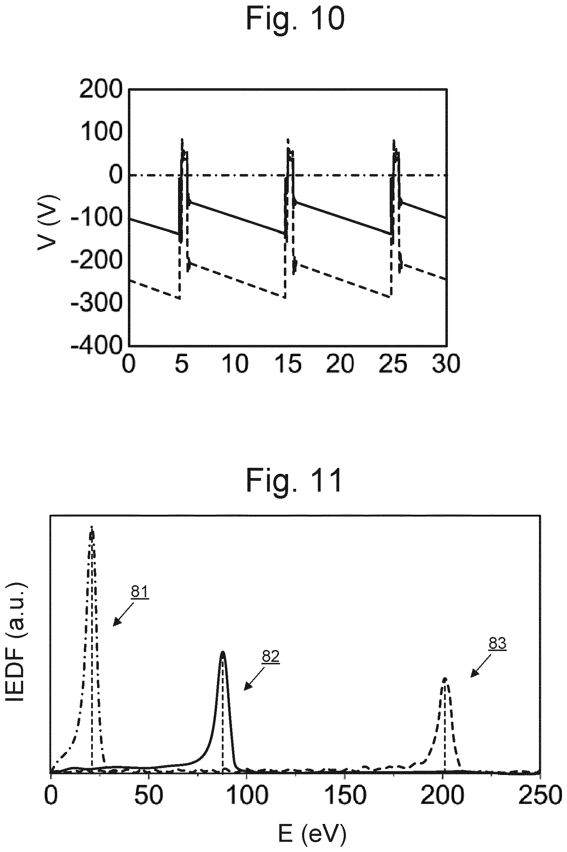

As explained above in the context of sinusoidal bias voltage waveforms, the distribution of energies of ions can be shifted along the energy axis by varying the amplitude of the bias voltage waveform. This is illustrated in Figures 10 and 11. In Figure 10, three different bias voltage waveforms are shown with three different amplitudes and the same frequency. Figure 11 shows corresponding distributions of ion energies. Curve 81 (dot-dash line) shows the distribution of energies resulting from applying the lowest amplitude bias voltage waveform in Figure 10. Curve 82 (solid line) shows the distribution of energies resulting from applying the intermediate amplitude bias voltage waveform in Figure 10. Curve 83 (broken line) shows the distribution of energies resulting from applying the highest amplitude bias voltage waveform in Figure 10. The curves 81-83 are example mono-modal curves of the same type as curve 42 shown in Figure 4. The mono-modal form is achieved by using the respective non-sinusoidal waveforms shown in Figure 10. In contrast to the sinusoidal case discussed above with reference to Figures 7 and 8, as the amplitude is increased it is seen that the spread of energies neither increases significantly in width nor becomes bimodal. The non-sinusoidal bias voltage waveform therefore allows flexible control of the distribution of energies of ions without the distribution becoming spread out or bimodal.

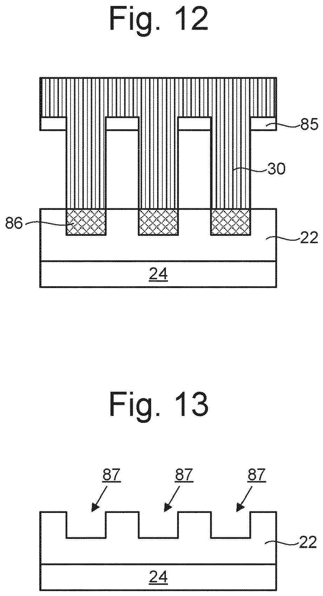

In the embodiments described above with reference to Figures 3-11, material was removed from the target layer 22 by the plasma during the irradiation. In other embodiments, the material may be removed from the target layer 22 in a separate step after the irradiation. The separate step may, for example, comprise selectively removing material based on whether the material has been modified by the plasma. Such an embodiment is depicted schematically in Figures 12 and 13. As depicted in Figure 12, the target layer 22 is irradiated by a patterned beam 30 of electromagnetic radiation. The pattern is defined by a mask 85. The irradiation may be performed using any of the configurations described above with reference to Figures 3-11. The irradiation modifies regions 86 in the target layer 22. The modification may be caused by the local interaction between the plasma pattern generated by the patterned beam 30 and the target layer 22. As with the embodiments described above with reference to Figures 3-11, a bias voltage may be applied to the substrate during the irradiation to control the distribution of energies of ions of the plasma impinging on the target layer 22. The bias voltage may be configured in any of the ways described above. Controlling the distribution of ion energies to be monomodal and/or narrowly spread in energy allows the target layer 22 to be modified efficiently, promoting high throughput and/or reducing or avoiding damage to adjacent materials or underlying layers. Figure 13 depicts the result of the separate step in which material of the target layer 22 is selectively removed based on whether the material has been modified or not by the plasma. In this embodiment, material corresponding to the modified regions 86 is removed to leave behind etched regions 87. The etched regions 87 define a pattern applied to the target layer 22. The applied pattern corresponds to the pattern of the patterned beam 30. In the example shown, the method removes material of the target layer 22 that has been modified by the plasma and leaves behind material that has not been modified. In other embodiments, the method may be configured to remove material that has not been modified by the plasma and leave behind material that has been modified.

In one embodiment, the plasma may for example cause oxidisation of the target layer 22 in a pattern defined by the plasma pattern, and the separate step may comprise selectively removing material depending on whether the material has been oxidised by the plasma. Such a methodology would be applicable for example in the case where the target layer comprises, consists essentially of, or consists of, Ru or Pa. In such a case, the modified regions 86 would comprise RuOₓ or PaOₓ. The controlled gaseous environment above the target layer 22 during the irradiation would be made to contain O₂ in this embodiment. The RuOₓ or PaOₓ patterns can be removed in a subsequent atomic layer etching step under HCOOH vapour to create a patterned film of Ru or Pa. This approach provides a convenient resist-free way of patterning features, with small critical dimensions. For example, a critical dimension of around 10nm could be achieved with exemplary exposure settings of k = 0.25, λ = 13.5nm, and numerical aperture, NA = 0.33. The use of the bias voltage may allow the target layer 22 to be modified more deeply, thereby creating a thicker modified layer than might be possible with an unbiased target layer. Creating a thicker modified layer allows material to be removed to a corresponding greater depth in the separate step.

Embodiments of the disclosure are defined in the following numbered clauses.
1. A method of patterning a target layer on a substrate by selectively removing material from the target layer, wherein the method comprises:
   irradiating the target layer with a patterned beam of electromagnetic radiation, the patterned beam generating a plasma in a plasma pattern that locally interacts with the target layer to define where material is to be removed from the target layer; and
   applying a bias voltage to the substrate during the irradiation to control a distribution of energies of ions of the plasma impinging on the target layer.
2. The method of clause 1, wherein the radiation has a wavelength below 100nm.
3. The method of clause 1 or 2, wherein the material is removed from the target layer by the plasma during the irradiation.
4. The method of clause 1 or 2, wherein the material is removed from the target layer in a separate step after the irradiation.
5. The method of clause 4, wherein the separate step comprises selectively removing material based on whether the material has been modified by the plasma.
6. The method of clause 4, wherein the plasma causes oxidisation of the target layer in a pattern defined by the plasma pattern and the separate step comprises selectively removing material depending on whether the material has been oxidised by the plasma.
7. The method of clause 6, wherein the target layer comprises Ru or Pa.
8. The method of any preceding clause, wherein the distribution of energies of ions is controlled such that removal of material from the target layer is performed selectively with respect to material in a layer adjacent to the target layer and having a different composition to the target layer.
9. The method of clause 8, wherein the distribution of energies of ions comprises a maximum between a first threshold energy defining a minimum ion energy for etching material of the target layer and a second threshold energy defining a minimum ion energy for etching the material adjacent to the target layer.
10. The method of clause 9, wherein all local maxima in the distribution of energies of ions are between the first and second threshold energies.
11. The method of clause 9, wherein the distribution of energies comprises a single maximum and the single maximum is between the first and second threshold energies.
12. The method of any preceding clause, wherein the bias voltage comprises a radio frequency bias voltage waveform.
13. The method of clause 12, wherein the bias voltage waveform has a frequency of less than 1 MHz.
14. The method of clause 12 or 13, wherein the bias voltage waveform is non-sinusoidal.
15. The method of clause 14, wherein each period of the bias voltage waveform comprises:
   a negative bias portion during which positive ions of the plasma are attracted towards the target layer; and
   a positive bias portion during which electrons of the plasma are attracted towards the target layer.
16. The method of clause 15, wherein the voltage of the bias voltage waveform varies during at least a majority of the negative bias portion in such a manner as to at least partially compensate for charging of the target layer and/or substrate caused by impingement of the ions during the negative bias portion.
17. The method of clause 16, wherein the variation of the voltage of the bias voltage waveform during the negative bias portion is substantially linear during at least a majority of the negative bias portion.
18. The method of clause 16 or 17, wherein the variation of the voltage of the bias voltage waveform during the negative bias portion is such as to maintain a substantially time invariant electric field within a sheath volume directly adjacent to the target layer during the negative bias portion.
19. The method of any of clauses 15-18, wherein the duration of the positive bias portion is selected such that ions continue to flow to the target layer due to inertial effects during all of the positive bias portion.
20. The method of any of clauses 15-19, wherein the duration of the positive bias portion is less than 1/4 of the period of the bias voltage waveform.
21. The method of any of clauses 15-20, wherein the voltage of the bias voltage waveform is substantially constant during at least a majority of the positive bias portion.
22. The method of any preceding clause, wherein the substrate is held in a controlled gaseous environment in a container arrangement during the irradiation by the patterned beam.
23. The method of clause 22, wherein the container arrangement comprises a pellicle and the patterned radiation beam passes through the pellicle onto the target layer during the irradiation.
24. The method of clause 23, wherein a plasma-forming voltage bias is applied to the pellicle during the irradiation by the patterned beam to promote formation of the plasma.
25. The method of any of clauses 22-24, wherein the gaseous environment comprises: 1) one or more inert gases; and/or 2) one or more chemically reactive gases.
26. The method of any preceding clause, wherein the target layer comprises a two-dimensional material.
27. The method of any preceding clause, wherein the target layer is provided as a spatially uniform layer prior to the irradiation by the patterned beam.
28. An apparatus for patterning a target layer on a substrate, comprising:
   a substrate table configured to support a substrate having a target layer;
   a projection system configured to irradiate the target layer by projecting a patterned beam of electromagnetic radiation onto the target layer;
   a container arrangement configured to contain the target layer in a controlled gaseous environment during the irradiation of the target layer by the patterned beam, the controlled gaseous environment being such that the patterned beam generates a plasma in a plasma pattern to define where material is to be removed from the target layer; and
   a plasma-controlling bias voltage unit configured to apply a bias voltage to the substrate during the irradiation to control a distribution of energies of ions of the plasma impinging on the target layer.
29. The apparatus of clause 28, wherein the container arrangement comprises a pellicle, the pellicle being substantially transparent to the patterned beam and configured to limit or prevent movement of particles through the pellicle.
30. The apparatus of clause 29, further comprising a plasma-forming bias voltage unit configured to apply a bias voltage to the pellicle, the bias voltage applied by the plasma-forming bias voltage unit being such as to promote formation of a plasma in the container arrangement.
31. The apparatus of any of clauses 28-30, wherein the container arrangement is configured to maintain the controlled gaseous environment at a pressure below atmospheric pressure.
32. The apparatus of any of clauses 28-31, wherein the projection system is configured to irradiate the target layer by projecting a patterned radiation beam having a wavelength below 100nm.
33. The apparatus of any of clauses 28-32, wherein the plasma-controlling bias voltage unit is configured to control the distribution of energies of ions such that removal of material from the target layer is performed selectively with respect to material in a layer adjacent to the target layer and having a different composition to the target layer.
34. The apparatus of clause 33, wherein the distribution of energies of ions comprises a maximum between a first threshold energy defining a minimum ion energy for etching material of the target layer and a second threshold energy defining a minimum ion energy for etching the material adjacent to the target layer.
35. The apparatus of clause 34, wherein all local maxima in the distribution of energies of ions are between the first and second threshold energies.
36. The apparatus of clause 34, wherein the distribution of energies comprises a single maximum and the single maximum is between the first and second threshold energies.
37. The apparatus of any of clauses 28-36, wherein the plasma-controlling bias voltage unit is configured such that the bias voltage comprises a radio frequency bias voltage waveform.
38. The apparatus of clause 37, wherein the bias voltage waveform has a frequency of less than 1 MHz.
39. The apparatus of clause 37 or 38, wherein the bias voltage waveform is non-sinusoidal.
40. The apparatus of clause 39, wherein each period of the bias voltage waveform comprises:
   a negative bias portion during which positive ions of the plasma are attracted towards the target layer; and
   a positive bias portion during which electrons of the plasma are attracted towards the target layer.
41. The apparatus of clause 40, wherein the voltage of the bias voltage waveform varies during at least a majority of the negative bias portion in such a manner as to at least partially compensate for charging of the target layer and/or substrate caused by impingement of the ions during the negative bias portion.
42. The apparatus of clause 41, wherein the variation of the voltage of the bias voltage waveform during the negative bias portion is substantially linear during at least a majority of the negative bias portion.
43. The apparatus of clause 41 or 42, wherein the variation of the voltage of the bias voltage waveform during the negative bias portion is such as to maintain a substantially time invariant electric field within a sheath volume directly adjacent to the target layer during the negative bias portion.
44. The apparatus of any of clauses 40-43, wherein the duration of the positive bias portion is selected such that ions continue to flow to the target layer due to inertial effects during all of the positive bias portion.
45. The apparatus of any of clauses 40-44, wherein the duration of the positive bias portion is less than 1/4 of the period of the bias voltage waveform.
46. The apparatus of any of clauses 40-45, wherein the voltage of the bias voltage waveform is substantially constant during at least a majority of the positive bias portion.
47. The apparatus of any of clauses 28-46, wherein the gaseous environment comprises: 1) one or more inert gases; and/or 2) one or more chemically reactive gases.
48. The apparatus of any of clauses 28-47, wherein the target layer comprises a two-dimensional material.

## Claims

1. A method of patterning a target layer on a substrate by selectively removing material from the target layer, wherein the method comprises:
irradiating the target layer with a patterned beam of electromagnetic radiation, the patterned beam generating a plasma in a plasma pattern that locally interacts with the target layer to define where material is to be removed from the target layer; and
applying a bias voltage to the substrate during the irradiation to control a distribution of energies of ions of the plasma impinging on the target layer.

2. The method of claim 1, wherein the radiation has a wavelength below 100nm.

3. The method of claim 1 or 2, wherein the material is removed from the target layer by the plasma during the irradiation.

4. The method of claim 1 or 2, wherein the material is removed from the target layer in a separate step after the irradiation, the separate step comprising selectively removing material based on whether the material has been modified by the plasma.

5. The method of any preceding claim, wherein the distribution of energies of ions is controlled such that removal of material from the target layer is performed selectively with respect to material in a layer adjacent to the target layer and having a different composition to the target layer.

6. The method of claim 5, wherein the distribution of energies of ions comprises a maximum between a first threshold energy defining a minimum ion energy for etching material of the target layer and a second threshold energy defining a minimum ion energy for etching the material adjacent to the target layer, wherein all local maxima in the distribution of energies of ions are between the first and second threshold energies or the distribution of energies comprises a single maximum and the single maximum is between the first and second threshold energies.

7. The method of any preceding claim, wherein the bias voltage has a comprises a radio frequency bias voltage waveform having a frequency of less than 1 MHz.

8. The method of claim 6 or 7, wherein the bias voltage waveform is non-sinusoidal.

9. The method of claim 8, wherein each period of the bias voltage waveform comprises:
a negative bias portion during which positive ions of the plasma are attracted towards the target layer; and
a positive bias portion during which electrons of the plasma are attracted towards the target layer.

10. The method of claim 9, wherein the voltage of the bias voltage waveform varies during at least a majority of the negative bias portion in such a manner as to at least partially compensate for charging of the target layer and/or substrate caused by impingement of the ions during the negative bias portion.

11. The method of claim 10, wherein the variation of the voltage of the bias voltage waveform during the negative bias portion is substantially linear during at least a majority of the negative bias portion.

12. The method of claim 10 or 11, wherein the variation of the voltage of the bias voltage waveform during the negative bias portion is such as to maintain a substantially time invariant electric field within a sheath volume directly adjacent to the target layer during the negative bias portion.

13. The method of any of claims 9-12, wherein the duration of the positive bias portion is less than 1/4 of the period of the bias voltage waveform.

14. The method of any of claims 9-13, wherein the voltage of the bias voltage waveform is substantially constant during at least a majority of the positive bias portion.

15. An apparatus for patterning a target layer on a substrate, comprising:
a substrate table configured to support a substrate having a target layer;
a projection system configured to irradiate the target layer by projecting a patterned beam of electromagnetic radiation onto the target layer;
a container arrangement configured to contain the target layer in a controlled gaseous environment during the irradiation of the target layer by the patterned beam, the controlled gaseous environment being such that the patterned beam generates a plasma in a plasma pattern to define where material is to be removed from the target layer; and
a plasma-controlling bias voltage unit configured to apply a bias voltage to the substrate during the irradiation to control a distribution of energies of ions of the plasma impinging on the target layer.
